# EUROPÄISCHE PATENTANMELDUNG

(11) **EP 1 130 470 A2**
(43) Veröffentlichungstag der Anmeldung: **05.09.2001**
(21) Anmeldenummer: 01101481.8
(22) Anmeldetag: 24.01.2001
(51) Int. Cl.: G03F 7/20, G02B 17/08

(54) **Mikrolithographie-Projektionsbelichtung mit tangentialer Polarisation**

(30) Priorität: 03.03.2000 DE 10010131
(71) Anmelder: Carl Zeiss, 89518 Heidenheim (Brenz) (DE); Carl Zeiss Stiftung Trading as Carl Zeiss, 89518 Heidenheim (DE)
(72) Erfinder: Schuster, Karlheinz, 89551 Königsbronn (DE); Wagner, Christian, Dr., 73430 Aalen (DE); Schriever, Martin, Dr., 73431 Aalen (DE)

(57) **Zusammenfassung**

Verfahren und Vorrichtung zur Mikrolithographie-Projektionsbelichtung bei hoher Apertur erfahren eine Kontraststeigerung durch Polarisation des Lichts senkrecht zur Einfallsebene am Resist. Anordnungen mit Beeinflussung der Polarisation als tangentiale oder an Dipolbeleuchtung angepaßte lineare Polarisation im Beleuchtungssystem und im Reduktionsobjektiv werden angegeben.

## Beschreibung

Die Erfindung betrifft ein Verfahren der mikrolithographischen Bilderzeugung mit polarisiertem Licht nach dem Oberbegriff des Anspruchs 1 sowie eine entsprechende Projektionsbelichtungsanlage in den Varianten der Oberbegriffe der Ansprüche 2 und 7.

Derartige Verfahren und Vorrichtungen sind aus DE 195 35 392 A (US Ser. No. 09/352 408) und den dort zitierten Schriften bekannt.

Die dort vorgeschlagene radiale Polarisation ist für Objektive mit typischer bildseitiger numerischer Apertur NA = 0,5 - 0,7 und Resist ohne Antireflex-Schicht gut geeignet zur Unterdrückung von Störungen aufgrund der polarisations-selektiven Reflexion am Resist unter Einfallswinkeln im Bereich des Brewster-Winkels.

Aus der US 5,365,371 und der US 5,436,761 ist dabei die Anordnung polarisationsselektiver Mittel für radiale Polarisation auch in der Pupillenebene (Systemapertur) des Projektionsobjektivs bekannt.

Aus der US 5,691,802 ist ein katadioptrisches Projektionsobjektiv bekannt, in dessen Pupillenebene eine polarisierende Platte angeordnet werden kann. Diese Platte hat eine innere Kreiszone und eine äußere Ringzone, die zueinander orthogonal linear polarisiertes Licht erzeugen und zugleich verschiedenen Brechungsindex haben. Damit werden zwei nicht interferierende Lichtbündel geschaffen, die unterschiedliche Bildebenen erzeugen. Eine Beziehung zur Beleuchtungsart ist nicht angegeben. Die numerische Apertur der gegebenen Beispiele beträgt höchstens 0,6.

Aus der US 4,755,027 sind Axicon-Anordnungen sowohl zur Erzeugung von radial wie auch von tangential polarisiertem Licht bekannt.

Aufgabe der Erfindung ist die Bereitstellung eines gattungsgemäßen Verfahrens und von entsprechenden Vorrichtungen, die bei weiter gesteigerter bildseitiger numerischer Apertur von ca. 0,7 bis über 0,9 hinsichtlich der Polarisationseffekte optimiert sind.

Bei antireflexbeschichtetem Resist (lichtempfindliche Schicht in der Bildebene) und weiter gesteigerter bildseitiger numerischer Apertur NA wird der Interferenzkontrast bestimmend. Dieser ist optimal, wenn die Zweistrahlinterferenz von Strahlen mit senkrecht zur Einfallsebene (sagittal, σ) orientierter Polarisation erfolgt. Eine Kontrasterhöhung von rund 7 % ist so beispielsweise möglich.

Gelöst wird diese Aufgabe mit dem Verfahren nach Anspruch 1, bei dem die in die Bildebene einfallenden und zum Bild interferierenden Lichtbündel eine senkrecht zur Einfallsebene orientierte Vorzugsrichtung der Polarisation aufweisen.

Die Vorrichtung nach Anspruch 2 weist dazu im Beleuchtungssystem ein Teilsystem auf, das zu mehr als 60%, vorzugsweise zu mehr als 70%, tangential polarisiertes Licht erzeugt.

Im weiteren Strahlengang muß diese Polarisation erhalten bleiben.

Die Vorrichtung nach Anspruch 7 sieht für den Fall eines katadioptrischen Reduktionsobjektivs vor, daß nach dem bildseitig letzten Spiegel eine Anordnung die Polarisation gemäß der eingestellten Geometrie der Pupillenausleuchtung beeinflußt und tangentiale Polarisation der zur Bildentstehung beitragenden Lichtbündel bewirkt.

Vorteilhafte Ausführungsformen sind Gegenstand der Unteransprüche.

Die Ansprüche 3 und 4 fordern Ringaperturbeleuchtung beziehungsweise Dipolbeleuchtung. Erfindungsgemäß wird in der Beleuchtung eine solche Polarisation bereitgestellt und im Strahlengang aufrechterhalten. Mit diesen können die Potentiale der hohen numerischen Apertur und der erfindungsgemäßen Polarisation optimal ausgenutzt werden.

Tangentiale Polarisation ist für Ringaperturbeleuchtung (annular) geeignet wie für Dipolbeleuchtung.
Für Dipolbeleuchtung ist auch lineare Polarisation gemäß Anspruch 5 geeignet, die mit der Dipolrichtung zu drehen ist.
Mit Quadrupolbeleuchtung ist die Erfindung nicht vorteilhaft.

Eingriffe in das Beleuchtungssystem sind regelmäßig einfacher als ins Reduktionsobjektiv, daher ist in Anspruch 2 die Bereitstellung der tangentialen Polarisation im Beleuchtungssystem vorgesehen. Dann muß diese Polarisation im Reduktionsobjektiv erhalten bleiben. Es ist daher vorteilhaft, wenn das Projektionsobjektiv (Reduktionsobjektiv) im Strahlengang rotationssymmetrisch aufgebaut ist, insbesondere als refraktives Objektiv oder als achssymmetrisches katadioptrisches Objektiv, letzteres zum Beispiel nach DE 196 39 586 (US Ser. No. 09/263788).

Zur Optimierung der gleichmäßigen erfmdungsgemäßen Polarisation in der Bildebene ist es vorteilhaft, wenn gemäß Anspruch 8 Störeinflüsse, serienmäßige oder exemplarspezifische, der optischen Elemente, welche auf die die Polarisation beeinflussende Anordnung folgen, vorgehalten werden und somit in der Bildebene ausgeglichen werden.

Anspruch 9 betrifft die Verwendung der beanspruchten Projektionsbelichtungsanlage im Verfahren nach Anspruch 1.

Das Verfahren nach Anspruch 10 sieht eine polarisationsneutrale mikrolithographische Maske vor, damit die beleuchtungsseitig erzeugte Polarisation nicht gestört wird. Besonders sind dabei Transmissionsmasken mit im Durchtritt nicht doppelbrechendem Substrat bevorzugt.

Nach Anspruch 11 ist eine Antireflexbeschichtung der lichtempfindlichen Schicht (Resist) des zu belichtenden Objekts (Wafer) vorgesehen, da sonst das Licht zu schwach in die Schicht einkoppelt bei den hohen Einfallswinkeln welche der numerischen Apertur im Bereich von 0,7 bis 0,9 und darüber entsprechen.

Gemäß Anspruch 12 kann dann vorzugsweise diese Antireflexbeschichtung speziell für das senkrecht zur Einfallsebene polarisierte Licht optimiert werden, was eine deutliche Vereinfachung gegenüber der sonst erforderlichen Optimierung für alle Polarisationsrichtungen bedeutet.

Die Erfindung wird anhand der Zeichnung näher erläutert.
- Fig. 1: zeigt schematisch eine Projektionsbelichtungsanlage mit Tangentialpolarisator im katadioptrischen Reduktionsobjektiv.
- Fig.2: zeigt schematisch eine Projektionsbelichtungsanlage mit Tangentialpolarisator im Beleuchtungssystem.
- Fig.3: zeigt schematisch die tangentiale Polarisation im Ausgang des tangentiale Polarisation erzeugenden Elements.
- Fig.4: zeigt schematisch die Situation der bilderzeugenden Lichtbüschel am Wafer.
- Fig.5: zeigt schematisch die Lichtbüschel in der Pupillenebene.

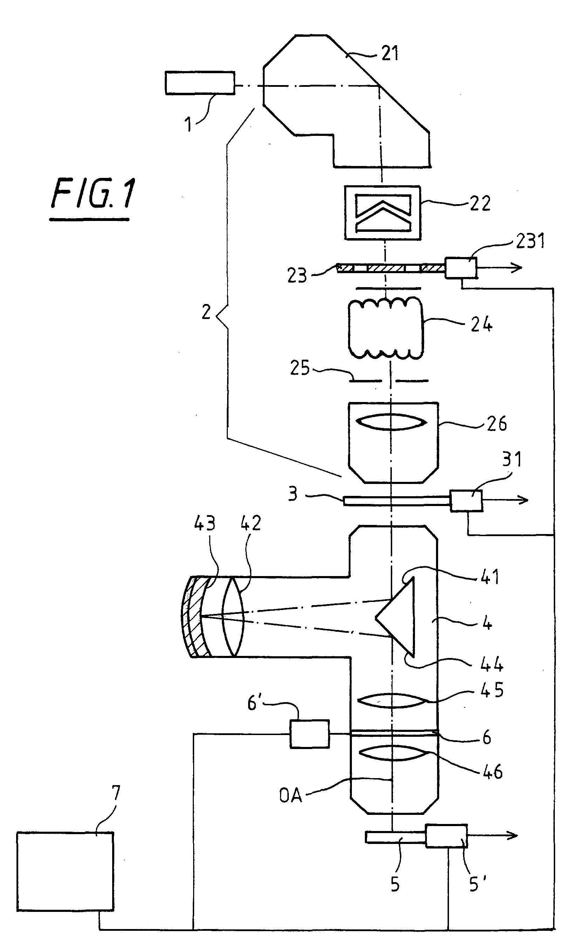

Die Projektionsbelichtungsanlage der Fig. 1 besteht aus der Lichtquelle 1, dem Beleuchtungssystem 2, dem Masken-Positionier-System 3, 31, dem Reduktionsobjektiv 4, dem Objekt-Positionier-System 5, 5' und einer Computersteuerung 7, neben nicht dargestellten weiteren üblichen Hilfseinrichtungen.

Die Lichtquelle 1 ist im Beispiel ein Excimer-Laser für DUV-Licht, insbesondere mit 193 nm oder 157 nm Wellenlänge.

Das Beleuchtungssystem 2 umfaßt typisch ein Strahlführungs- und formungs-System 21, eine Gruppe zur verlustarmen Formung verschiedener Beleuchtungssettings 22, zum Beispiel mit verstellbaren Axicons zur Formung einer Ringaperturbeleuchtung (annulare Beleuchtung), zusätzlich oder alternativ eine verstellbare Blendenanordnung 23 mit Stelltrieb 231 für das Beleuchtungssetting (Annulare, Dipol-, Quadrupol-, konventionelle Beleuchtung mit verschiedener Kohärenz), einen Lichtintegrator 24, hier dargestellt als Wabenkondensor, eine REMA-Blende 25 als Begrenzung des auf der Maske 3 ausgeleuchteten Feldes und ein REMA-Objektiv 26. Derartige Beleuchtungssysteme sind bekannt, vergleiche DE 198 55 106 A (US Appl. Filed Nov. 29, 1999) und dort angegebene Schriften.

Das Reduktionsobjektiv 4 ist katadioptrisch mit einem Konkavspiegel 43, Umlenkspiegeln 41, 44 und Linsen und Linsengruppen 42, 45, 46. Auch dieses ist insoweit bekannt, z. B. aus US Ser. No. 09/364,382 (EP 0989434 A). Eine Alternative sind z. B. Objektive mit Beamsplitter wie DE 199 54 727 A.

Diese Schriften und die darin zitierten Schriften sind als Beispiele für derartige Beleuchtungssysteme und Objektive voll Teil auch dieser Anmeldung.

Das katadioptrische Reduktionsobjektiv hat eine bildseitige numerische Apertur von NA = 0,8 oder mehr. Als Besonderheit ist darin, vorzugsweise im Bereich der Pupillenebene (Systemapertur) ein die Polarisation beeinflussendes Element 6 eingebaut. Dieses bewirkt im nachfolgenden Strahlengang tangentiale Polarisation. Aufgebaut ist es zum Beispiel aus segmentierten doppelbrechenden Platten ähnlich den für radiale Polarisation bekannten.
Im Fall der Dipolbeleuchtung mit entsprechend ausgebildeten und eingestellten Elementen 22, 23 des Beleuchtungssystems 2 kann das Element 6 auch linear polarisiertes Licht erzeugen. Mit einem Stellmittel 6' kann dann die Polarisationsrichtung an die Orientierung der Dipolbeleuchtung angepaßt werden. Das Element 6 kann ein filternder Linearpolarisator sein. Bevorzugt wird ein verlustarm wirkendes doppelbrechendes Element eingesetzt. Wird von dem Beleuchtungssystem 2 zirkular polarisiertes Licht bereitgestellt, dann liegt nach den Spiegeln 41, 43, 44 aufgrund ihrer polarisationsabhängigen Reflexionsgrade elliptische Polarisation vorbestimmbarer Geometrie vor, die durch eine doppelbrechende Platte passender Dicke zu linearer Polarisation umgeformt werden kann. Es ist vorteilhaft, wenn die Spiegel 41, 43, 44 mit phasenerhaltenden Reflexschichten belegt werden.

Die Maske 3 (Retikel) und das zu belichtende Objekt 5 (Wafer) sind in der Objekt- und Bildebene angeordnet und werden mit Positioniersystemen 31, 5'zugeführt, genau ausgerichtet und im Step-and-Scan-Verfahren synchronisiert bewegt.

Diese Positioniersysteme 31, 5' wie die Einstellvorrichtung 231 in der Beleuchtung und das Stellmittel 6' für das polarisationsbestimmende Element 6 werden von der Computersteuerung 7 angesteuert. Diese kann in bekannter Weise das gesamte Projektionsbelichtungssystem steuern und dabei auch weitere Signalgrößen und Stellgrößen berücksichtigen.

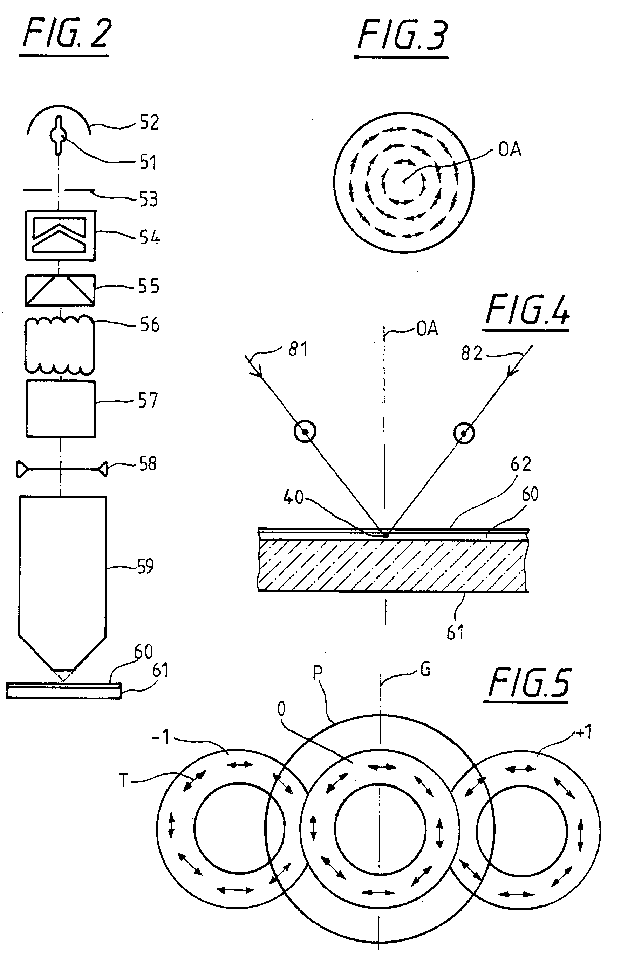

Fig. 2 zeigt einen alternativen Systemaufbau mit tangential polarisierender Anordnung 55 im Beleuchtungssystem. Diese kann eine Axicon-Anordnung nach US 4,755,027 sein. Dort ist auch beschrieben, wie für verschiedene Vorpolarisation des ankommenden Lichts optimale Ergebnisse erzielt werden können. Außer dieser sind alle Teile und ihre Anordnung branchenüblich. Eine Lichtquelle 51 mit Spiegel 52 beleuchtet eine Blende 53. Ein Objektiv 54, zum Beispiel ein Zoom-Axicon-Objektiv nach DE 44 21 953 A, folgt und ermöglicht verschiedene Einstellungen, insbesondere die Wahl einer Ringapertur. Auf die Anordnung 55 folgt ein Wabenkondensor 56 und eine Relais- und Feldoptik 57. Diese Teile zusammen dienen der optimierten Beleuchtung des Retikels 58, das durch das Reduktionsobjektiv 59 verkleinert mit höchster Auflösung - unterhalb 100 nm bis 70 nm oder 50 nm -auf den Resist-Film 60 des Wafers 61 abgebildet wird. Der Resist-Film 60 umfaßt hier eine AntireflexBeschichtung, da bei den hohen Inzidenzwinkeln im Bereich des Brewster-Winkels, verstärkt noch durch die Polarisationsrichtung senkrecht zur Einfallsebene, ohne diese keine wirksame Einkopplung des Lichts in den Resist-Film 60 erfolgt.

Fig. 3 verdeutlicht die tangentiale Polarisation am Ausgang des Polarisators 55 bzw. 6, wie sie auch in jeder nachfolgenden Pupillenebene des Systems zentriert zur optischen Achse OA vorliegt.

Fig. 4 verdeutlicht die Situation bei der Einkopplung der bilderzeugenden Lichtbündel 81, 82 in den Resistfilm 60. Die unter hohem Inzidenzwinkel bezüglich der optischen Achse OA einfallenden Büschel 81, 82 weisen erfindungsgemäß eine Polarisation senkrecht zur Einfallsebene und damit zur Zeichenebene auf. Durch die dafür optimierte Antireflexschicht 62 wird ihr effektives Eindringen in die Resistschicht 60 ermöglicht, wo sie in dem Bild"punkt" 40 aufgrund ihrer zueinander parallelen Vektoren des elektrischen Feldes effektiv interferieren, so daß ein hoher Kontrast zwischen belichteten Punkten 40 und unbelichteten Punkten entsteht. Die Dicken der Schichten 60, 62 und des Substrats 61 (Wafer) sind nicht maßstäblich, auch wurde die Brechung an den Schichtgrenzen nicht dargestellt.

Fig. 5 zeigt eine Simulation der Lichtverteilung in einer Pupillenebene des Reduktionsobjektivs, also zum Beispiel am Austritt des Elements 6 in Fig. 1. Innerhalb des Pupillendurchmessers P liegt der von der Ringaperturbeleuchtung ausgeleuchtete Bereich 0. Dieser ist zugleich die nullte Beugungsordnung eines in Richtung G in der Ebene des Retikels (3 in Fig. 1) angeordneten Gitters, während -1 und +1 die Verteilungen der -1. und +1. Beugungsordnungen eines Gitters mit einer Gitterperiode im Bereich der Auflösungsgrenze darstellen. Die sich überlappenden Bereiche der Ringe -1, 0. +1 erzeugen das Bild. Leicht erkennt man, daß die mit den Pfeilen T angedeutete tangentiale Polarisation dazu führt, daß in diesen Überlappbereichen die beiden beteiligten Lichtbündel gleich polarisiert sind und somit positiv interferieren können.

Für ein 1:1 Gitter mit einem Stegabstand im Bild von 100 nm ergibt sich mit einer Projektionsbelichtungsanlage mit 193 nm Wellenlänge und bildseitiger numerischer Apertur NA = 0,75 bei Ringaperturbeleuchtung mit σ = 0,5-0,8 für einen Resist mit der Brechzahl n = 1,8 mit erfindungsgemäßer Polarisation eine relative Kontraststeigerung von 7% gegenüber unpolarisiertem Licht. Mit annularer Beleuchtung ist der Effekt unabhängig von der Strukturrichtung und ist das Verfahren für alle Strukturarten wie dichte Linien, Kontaktlöcher und so weiter geeignet. Wirksam ist das Ganze besonders bei Belichtungsverfahren mit niedrigem Kontrasterfordernis, also mit k-Faktoren im Bereich von etwa 0,3 bis 0,5. Die Orientierung von Dipolbeleuchtung ist auf die Orientierung der abzubildenden Strukturen auszurichten. Damit kann die auch vorgeschlagene lineare Polarisation in der Bildebene neben der tangentialen verwendet werden, wenn auch die Polarisationsrichtung der Strukturrichtung angepaßt wird - Polarisation parallel zu den Linien.

## Patentansprüche

1. Verfahren der mikrolithographischen Bilderzeugung mit polarisiertem Licht, dadurch gekennzeichnet, daß die in die Bildebene einfallenden und zum Bild interferierenden Lichtbündel (81, 82) eine senkrecht zur Einfallsebene orientierte Vorzugsrichtung der Polarisation aufweisen.

2. Projektionsbelichtungsanlage der Mikrolithographie umfassend
• eine Lichtquelle (51)
• ein Beleuchtungssystem, enthaltend ein die Polarisation beeinflussendes Teilsystem (55) und ein die Beleuchtungsapertur bestimmendes zweites Teilsystem (54)
• ein Masken-Positionier-System (58)
• ein Projektionsobjektiv (59), vorzugsweise mit einer bildseitigen numerischen Apertur im Bereich von 0,7 bis 0,95, mit Bildebene
• ein Objekt-Positionier-System (60, 61)
dadurch gekennzeichnet, daß
das die Polarisation beeinflussende Teilsystem (54) zu mehr als 60 %, vorzugsweise zu 70 % und mehr tangential polarisiertes Licht erzeugt.

3. Projektionsbelichtungsanlage nach Anspruch 2, dadurch gekennzeichnet, daß das zweite Teilsystem (54) Ringaperturbeleuchtung erzeugt.

4. Projektionsbelichtungsanlage nach Anspruch 2, dadurch gekennzeichnet, daß das zweite Teilsystem (54) Dipolbeleuchtung erzeugt.

5. Projektionsbelichtungsanlage nach Anspruch 4, dadurch gekennzeichnet, daß das die Polarisation beeinflussende Teilsystem (55) statt tangential polarisiertem Licht linear polarisiertes Licht mit der Polarisationsrichtung senkrecht zur Verbindungslinie der beiden Lichtflecke der Dipolbeleuchtung erzeugt

6. Projektionsbelichtungsanlage nach mindestens einem der Ansprüche 1 bis 5, dadurch gekennzeichnet, daß das Projektionsobjektiv (59) im Strahlengang rotationssymmetrisch aufgebaut ist, insbesondere als refraktives Objektiv oder als rotationssymmetrisches Objektiv.

7. Projektionsbelichtungsanlage der Mikrolithographie umfassend
- eine Lichtquelle (1) mit einer Wellenlänge im ultravioletten Bereich, insbesondere zwischen 200 nm und 100 nm
- ein Beleuchtungssystem (2) mit einer einstellbaren Vorrichtung (22) zur Erzeugung verschiedener Geometrie der Pupillenausleuchtung, insbesondere von Ringapertur- oder Dipolbeleuchtung verschiedener Varianten
- ein Masken-Positionier-System (31)
- ein katadioptrisches Reduktionsobjektiv (4), vorzugsweise mit einer bildseitigen numerischen Apertur im Bereich von 0,7 bis 0,95, mit einem bildseitig letzten Spiegel (44) und einer die Polarisation beeinflussenden Anordnung (6) nach diesem Spiegel (44)
dadurch gekennzeichnet, daß
die die Polarisation beeinflussende Anordnung (6) abgestimmt auf die eingestellte Geometrie der Pupillenausleuchtung einstellbar oder verstellbar ist, so daß die in der Bildebene (5, 60) die Bildentstehung bewirkenden Strahlbündel (81, 82) im wesentlichen senkrecht zur Einfallsebene polarisiert sind.

8. Projektionsbelichtungsanlage nach mindestens einem der Ansprüche 2 bis 7, dadurch gekennzeichnet, daß die die Polarisation beeinflussende Anordnung (55, 6) hinsichtlich der Polarisationsverteilung einen Vorhalt aufweist, der Störeinflüsse der nachfolgenden optischen Komponenten (46, 56 - 59) bis zur Bildebene (5, 61) ausgleicht.

9. Verfahren nach Anspruch 1, gekennzeichnet durch die Verwendung einer Projektionsbelichtungsanlage nach mindestem einem der Ansprüche 2 bis 8.

10. Verfahren nach Anspruch 1 oder Anspruch 9, dadurch gekennzeichnet, daß im Masken-Positionier-System (31) eine polarisationsneutrale mikrolithographische Maske (3) eingesetzt ist, insbesondere eine Transmissionsmaske, deren Substrat im Durchlaß im wesentlichen nicht doppelbrechend ist.

11. Verfahren nach Anspruch 1, 9 oder 10, wobei im Objektiv-Positionier-System (5') ein Objekt (5, 61) mit einer lichtempfindlichen Schicht (61) angeordnet ist, dadurch gekennzeichnet, daß die Schicht (61) mit einer Antireflexbeschichtung (62) versehen ist.

12. Verfahren nach Anspruch 11, dadurch gekennzeichnet, daß dieAntireflexschicht (62) optimal Licht mit Polarisationsrichtung senkrecht zur Einfallsebene transmittiert.
